Europäisches Patentamt

European Patent Office

Office européen des brevets

(11) Publication number: **0 241 913**
**A2**

(19)

# EUROPEAN PATENT APPLICATION

(21) Application number: **87105513.3**

(22) Date of filing: **14.04.87**

(51) Int. Cl.⁴: **H03M 1/22**

(30) Priority: **15.04.86 JP 87839/86**

(43) Date of publication of application:
**21.10.87 Bulletin 87/43**

(84) Designated Contracting States:
**CH DE GB LI SE**

(71) Applicant: **MITUTOYO MFG. CO., LTD.**
**5-31-19, Shiba**
**Minato-ku Tokyo(JP)**

(72) Inventor: **Andermo, Ingvar**
**5906-112th Place N.E.**
**Kirkland, WA 98033(US)**

(74) Representative: **Patentanwälte Grünecker,**
**Kinkeldey, Stockmair & Partner**
**Maximilianstrasse 58**
**D-8000 München 22(DE)**

(54) **Method and circuitry for detecting signals of capacitance type transducers for measuring positions.**

(57) Rows of transmitting and receiving electrodes are arranged on a first scale and a second scale which are used in calipers or micrometers and which are displaced relatively to each other. The fact that the capacity value between both sets of electrodes differs depending on the relative displacement positions of both scales is utilized to measure the relative positions of both scales.

The transmitting electrodes are provided with a number of A.C. signals having different phases, and the relative positions of both scales can be measured by the signals obtained from the receiving electrodes.

Signals of a first specific phase combination are supplied to the transmitting electrodes when both scales are stationary, and the signals received at this time are subjected to positive integration for a predetermined time. Next, transmitted signals of a second specific phase combination, different from the aforesaid phase combination, are supplied to the transmitting electrodes, the signals received are subjected to inverse integration, and the position between both scales is found from the time required until the integral value reaches zero.

FIG. 1

# METHOD AND CIRCUITRY FOR DETECTING SIGNALS OF CAPACITANCE TYPE TRANSDUCERS FOR MEASURING POSITIONS

## BACKGROUND OF THE INVENTION

### Field of the invention

This invention relates to a method and circuitry for detecting signals of capacitance type transducers for measuring positions. Specifically, it relates to improvements of the method for supplying transmission signals to transmitting electrodes and of the method for processing the corresponding received signals.

### Description of the Prior Art

Capacitance type transducers for measuring positions are well known. These are transducers in which transmitting electrodes and receiving electrodes are positioned on a first scale and a second scale, respectively, which are displaced relatively to each other, both groups of electrodes are coupled capacitively with each other, and the relative displacement distance between both scales is measured from the changes in the capacity value between the two groups of electrodes. Transducers of this type are applied in a broad range of uses, for example as instruments for measuring the positions on each axis in three-dimensional measuring devices, or as small-size length-measuring devices such as calipers or micrometers.

Ordinarily, in order to detect the changes in the capacity values between both groups of electrodes, the transmitting electrodes are supplied with a number of A.C. signals of different phases. It is possible to discover electrically the aforesaid capacity values, and the relative displacement distance, because the values of the received signals obtained from the receiving electrodes change in accordance with the capacity values of both sets of electrodes at this time.

Various advantages can be obtained by using the conventional length-measuring devices of this type using the electrostatic capacity. For example, electrical signal detection can be performed between both scales without using contacts. The devices have a high durability. In addition, the measuring sensitivity of the length-measuring devices can be improved by dividing the received signals obtained.

Nevertheless, the method generally used in the past in order to detect the aforesaid capacity values was one in which specified phase combinations were supplied to the transmitting electrodes, and the received signals obtained at this time were processed. The phase method is a well-known example of the aforesaid signal-processing method.

In the phase method of the past, there occurred on the receiving side phase changes corresponding to the electrostatic capacity between both sets of electrodes, as compared to the phase combination supplied to the transmitting electrodes. In order to find these phase changes, the zero-crossing point in the received signals was found, and the relative displacement distance between both scales was determined in accordance with the position of the zero-crossing point in the received signals.

Consequently, there were problems such as the following in the method of the past. It was sufficient to supply a single set of combined signals to the transmitting electrodes. On the other hand, on the receiving side, the received signals were subjected to a predetermined filter effect. This filter effect would bring about a deterioration of the signal precision, and a considerable signal stabilizing time was required in order to process the received signals. As a result, there was an increased waiting time before the measured values could be obtained.

This invention was made in consideration of the aforesaid tasks of the past, and its purpose is to provide improved circuitry for signal detection which has a good measuring precision and in which processing can be performed at a high speed, with only a short waiting time in measurement.

## SUMMARY OF THE INVENTION

In order to achieve the aforesaid purpose, in this invention transmitting is performed with two sets of phase combinations with different phase differences, unlike the method of the past in which one set of transmitted phase combinations was supplied, and the desired relative displacement distance was detected by processing the two sets of received signals obtained at this time.

Therefore, on the detection circuit side, it is possible to increase the amount of data required to determine the relative displacement distance by the two sets of received signals. In particular because the transmitted phase combinations are varied on the transmitting side, specific combinations of different received signals are obtained theoretically on the receiving side. By arithmetically processing these two sets of received signals, it is possible to obtain good-quality received signals extremely easily without passing them through filters which require a stabilizing time, as was necessary in the past. This makes possible rapid, undelayed processing.

It is preferable in this invention to subject the aforesaid two sets of received signals to positive integration for a predetermined time by the first set of signals, and next to subject these integral values to inverse integration by the second set of received signals. It is possible to obtain the relative displacement distance from the inverse integration time until a predetermined value, ordinarily zero, is reached.

In this invention, it is preferable for the aforesaid two sets of transmitted phase combinations to have an electrical phase difference of 90 degrees. If this is so, the relative displacement distance can be found quickly and easily by calculating a simple trigonometric function.

In this invention, in order to increase the ranges of lengths measured while also maintaining the measuring precision, a number of pairs of transmission signals with phase combinations having phase differences are prepared, and two sets of transmission signals are assigned to each of the aforesaid ranges of lengths to be measured. The desired relative displacement distances can be sought by trying these pairs of transmissions with different phase combinations one after another.

When this invention is applied, first the first set of transmission signals having a specified phase combination, for example eight transmission signals with phase differences of 45 degrees each, are supplied to the transmitting electrodes, which are divided into blocks of eight each.

The first set of received signals obtained in this state of transmission contains data about the aforesaid phase combination on the transmitting side as well as the value of the electrostatic capacity between both electrodes. These signals are stored in memory.

The aforesaid first set of received signals can be stored, for example by simply memorizing them as digital values, or they can also be stored as analog values after undergoing positive integration by a predetermined time in an integrator.

Next, after the aforesaid first set received signals has been stored, the phase combinations supplied to the transmitting electrodes are switched over to the second set of phase combinations, which have a predetermined phase difference differing from that of the aforesaid first set of specified phase combinations. In order to simplify calculation of the trigonometric function, it is desirable for the electrical phase differences in both these sets of transmission signals to be set, for example, at 90 degrees.

The second set of received signals is obtained as a result of this second transmission, and this second set of received signals is also stored in memory in the same way.

The aforesaid storage can be either digital or analog. If, for example, analog storage is used, the analog integral value obtained by positive integration during the aforesaid first transmission can also be subjected to inverse integration by the second set of received signals.

Once the first and second sets of received signals have both been stored in memory in this way, they can be processed by the arithmetic unit to find the desired relative displacement distances.

If analog calculation is performed as described above by positive integration and inverse integration, the inverse integration time until the aforesaid inverse integral value reaches a predetermined value, for example zero, can be found, and the arithmetic unit can determine the desired relative displacement distance from this inverse integration time.

BRIEF DESCRIPTION OF THE DRAWINGS

Fig. 1 is a block circuit diagram of the signal-detecting circuit of a capacitance type transducer of this invention for measuring positions.

Fig. 2 is a circuit diagram illustrating an embodiment of the transmitting circuit in Fig. 1.

Fig. 3 is an explanatory diagram illustrating the phase combinations in the transmission signals in Fig. 2.

Fig. 4 is a timing chart illustrating the operations of the measuring circuit illustrated in Fig. 1.

Fig. 5 is an explanatory diagram illustrating the basic principles of measurement in the measuring circuit illustrated in Fig. 1.

Fig. 6 is an explanatory diagram illustrating the two received signals and how they are subjected to positive integration and inverse integration in the measuring circuit in Fig. 1.

Fig. 7 is a flow chart illustrating the measuring procedure when measurements are made in the measuring circuit in Fig. 1.

Fig. 8 is an oblique drawing illustrating a suitable embodiment of a capacitance type transducer of this invention for measuring positions.

## DETAILED DESCRIPTION OF THE PREFERRED EMBODIMENT

In the following we explain a suitable embodiment of this invention on the basis of the drawings.

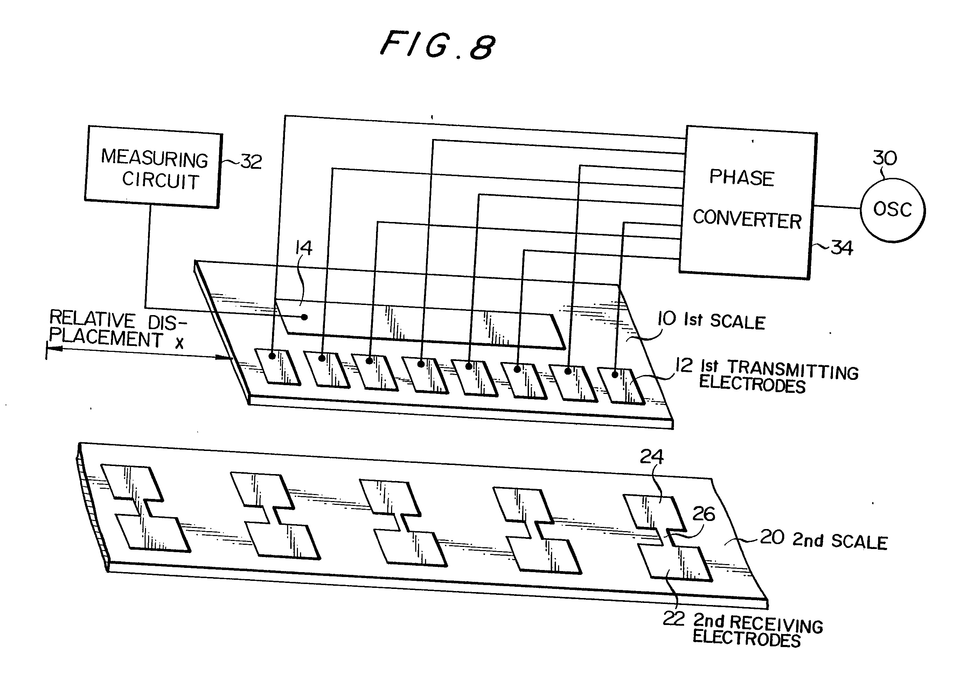

Fig. 8 shows the approximate configuration of a capacitance type transducer for measuring positions in which this invention is applied.

The transducer comprises a first scale 10 and a second scale 20. The first transmitting electrodes 12 are formed on the first scale 10 as a group of at least eight regularly aligned electrodes insulated from each other. Ordinarily, the electrodes are formed by methods such as vapor deposition on a first scale 10 consisting of an insulating material.

The second scale 20 also consists of an insulating material, and a number of second receiving electrodes 22 are regularly aligned on it along its longitudinal direction.

In Fig. 8, the signals received by the aforesaid second receiving electrodes 22 are detected after they have further been transmitted to the first scale 10 side. For this transmission of signals, second transmitting electrodes 24, which are electrically conducted to the aforesaid second receiving electrodes 22 by coupling electrodes 26, are provided on the aforesaid second scale 20. Furthermore, a first receiving electrode 14 is positioned on the first scale 10 side in a position corresponding to the second transmitting electrodes 24.

The aforesaid first transmitting electrodes 12 and the second receiving electrodes 22 are coupled capacitively with each other, and an electrostatic capacity corresponding to the relative displacement distance X between the two scales 10 and 12 is produced between both electrodes.

On the other hand, the aforesaid second transmitting electrodes 24 and first receiving electrode 14 are also coupled capacitively with each other, and the signals received by the second receiving electrodes 22 are returned by the capacitive coupling to the first receiving electrode 14, as will be understood.

The output of an oscillator 30 is supplied from a phase converter 34 to the aforesaid first transmitting electrodes 12 as a phase combination with different phases, for example with electrical phases differing by 45 degrees each. On the other hand, the received signals obtained by the first receiving electrode 14 are processed by the measuring circuit 32.

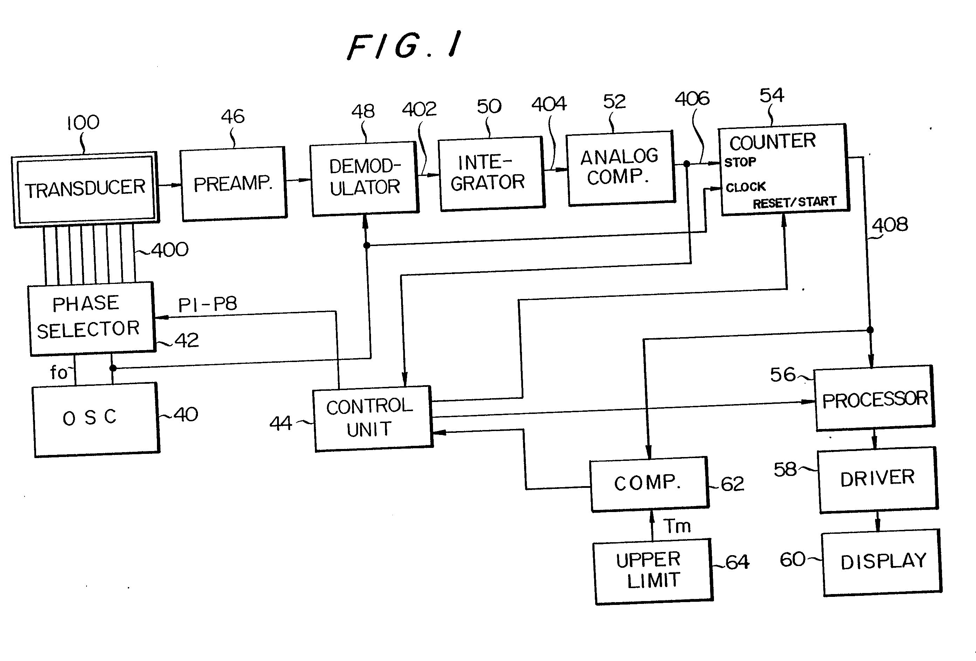

Fig. 1 illustrates an embodiment of the transmitting circuit and receiving circuit of the aforesaid transducer.

The transducer is shown in the figure by the numeral 100. As is clear from the foregoing explanation, this transducer 100 has a first scale and a second scale which are relatively displaced from each other. The aforesaid first scale is provided with the first transmitting electrodes, and the second scale is provided with the second transmitting electrodes. Both these electrodes are coupled capacitively with each other, and the value of the electrostatic capacity varies according to the relative displacement positions of both of them.

The first transmitting electrodes of the aforesaid transducer 100 are supplied with a number of A.C. signals modulated with different phases from the transmitting circuit. The transmitting circuit in this embodiment comprises an oscillator 40 and a transmitting phase switching circuit 42 and is able to supply to the transmitting electrodes A.C. signals modulated with any phase combination selected by the control unit 44.

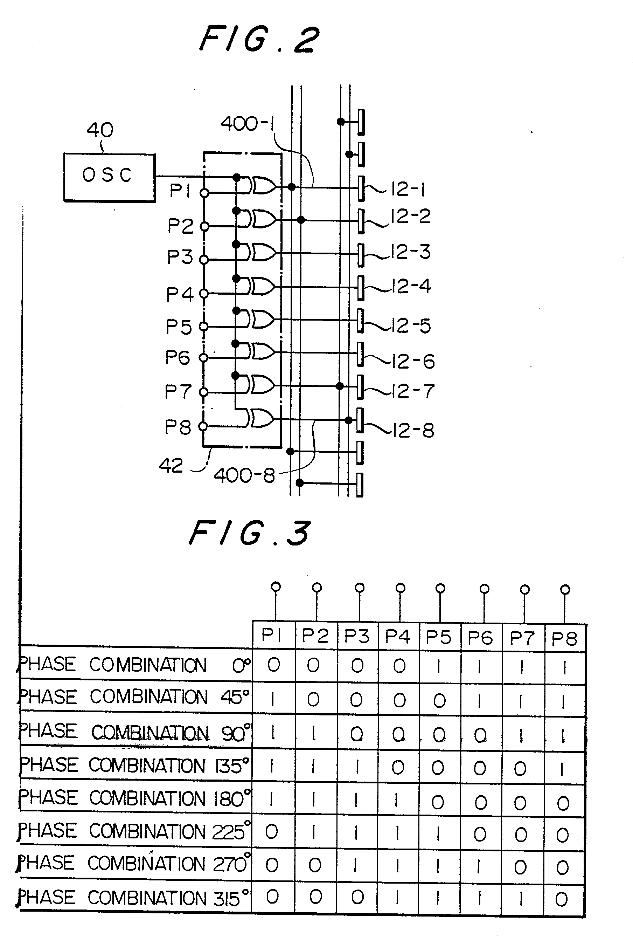

Fig. 2 illustrates an example of the transmitting circuit in this embodiment. The output obtained by modulating signals having eight transmitting phases differing by 45 degrees each with high-frequency signals from the oscillator 40 is supplied as a group to a number of transmitting electrodes 12-1 to 12-8.

The high-frequency signals of the oscillator 40 in this embodiment are A.C. signals with frequencies of, for example, about 100-200 KHz. They are subjected to modulation by eight exclusive OR gates located on the transmitting phase switching circuit 42.

Switching signals P1 - P8 are supplied from the control unit 44 to each of the exclusive OR gates on the aforesaid transmitting phase switching circuit 42. In this embodiment, the combinations of the aforesaid control signals P are set at eight different phases, from the first phase combination to the eighth phase combination, as shown in Fig. 3. The control unit 44 can selectively specify any of these eight phase combinations.

In actual fact, the aforesaid eight combinations will consist of signals giving phase differences of 45 degrees each to the signals received by transducer 100.

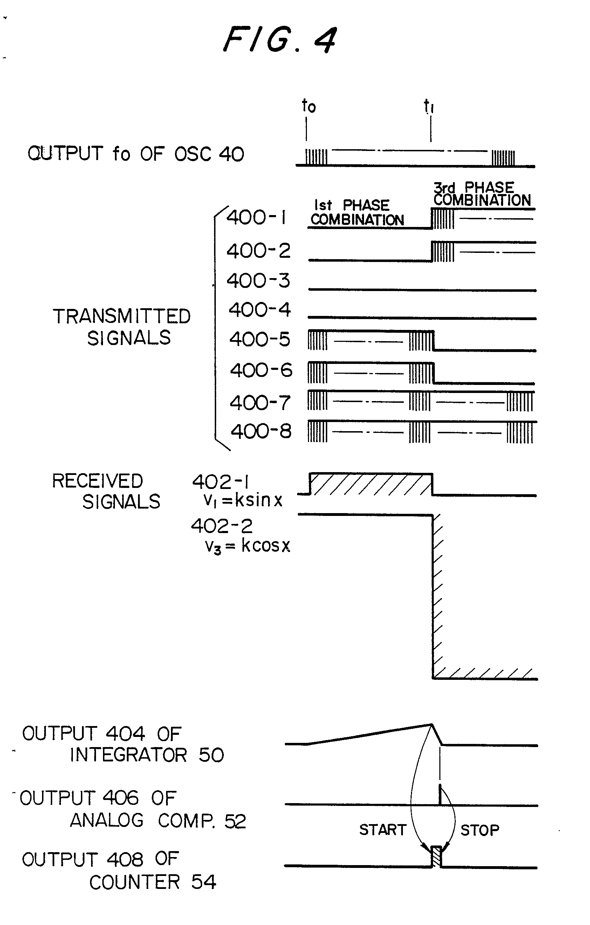

An explanatory diagram illustrating the operation of this example is given in Fig. 4. Its overall operation is described below, but the output $f_0$ of the aforesaid oscillator 40 is shown in this figure as trains of clock pulses, and the transmission signals 400 shown in Fig. 4 are signals of the first phase combination ($t_0$ - $t_1$) and of the third phase combination ($t_1$ -).

Let us explain this by using the first phase combination as an example. As is clear from Fig. 3, when the transmitting phase switching circuit 42 is set at the output of the first phase combination, P1 - P4 will be 0, and P5 - P8 will be 1. As a result, transmission signals 400 will be the signals shown in which clock pulses are output at 400-5 to 400-8 in Fig. 4.

If the actual transmitting phase switching circuit 42 shown in Fig. 2 is used, the circuit will consists of an exclusive OR gate. Therefore, transmission signals 400-1 to 400-4 in the first phase combination will contain clock pulses differing by a phase of exactly 180 degrees, but the clock pulses for these inversion phase signals are shown in Fig. 4 as blanked signals in order to make the explanation easier to understand.

Similarly, the third phase combination can be considered to be signals having at the receiving side a phase difference of 90 degrees from the first phase combination. In this case, transmission signals 400-1, 400-2, 400-7 and 400-8 will output clock pulses, and 400-3 to 400-6 will be supplied to the first transmitting electrodes 12 of each transducer 100 as blanked clock pulse signals (inverse signals).

It is not shown in detail in the figures, but in the other transmitted phase combinations shown in Fig. 3, eight transmission signals 400 are also combined similarly and supplied to the first transmission electrodes 12. This makes it possible for the transmitting circuit to supply transducer 100 with transmission signals having any eight different phase combinations selected at random.

Received signals corresponding to the aforesaid transmission signals are output from the receiving electrodes of the aforesaid transducer 100.

As for the output of the preamplifier 46, its receiving signal level is determined by the electrostatic capacity, which is determined by the relative positions of the first and second scales of transducer 100, that is, by the relative displacement position between its first transmitting electrodes and its second receiving electrodes. The preamplifier output is synchronously demodulated by the synchronous demodulator 48, as is shown in this embodiment, so that the output will have wave patterns modulated with the high-frequency signals. The output $f_0$ of the oscillator 40 is supplied to this demodulator 48 to provide a reference signal for the demodulation.

The output 402 of the synchronous demodulator 48 is determined by the transmitting phase of the transmitting circuit and the position of the transmitting electrodes of transducer 100. Received signals 402-1 and 402-2 are shown as examples of this in Fig. 4.

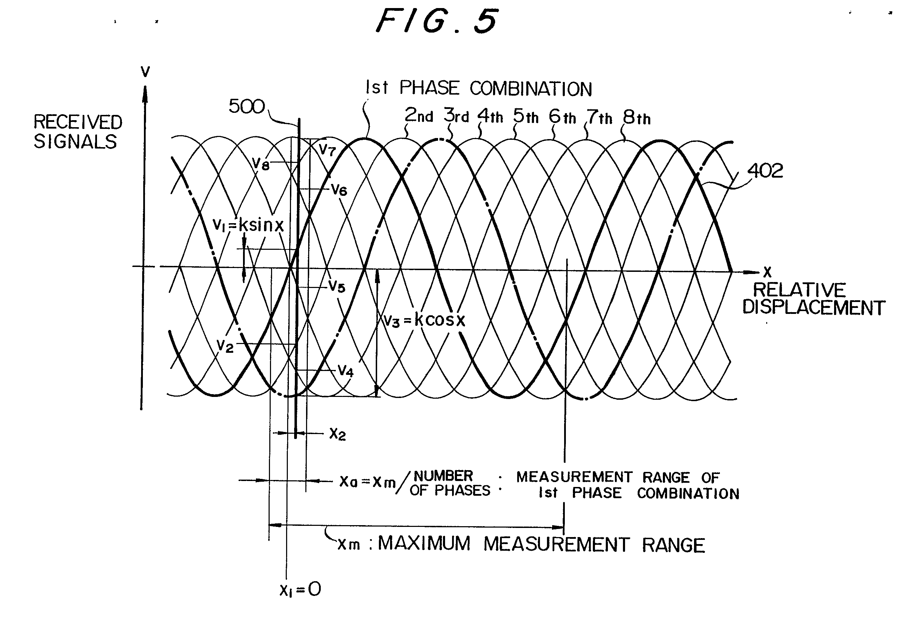

Fig. 5 illustrates the manner in which the received signals V differ in accordance with each of the transmitted phase combinations on the transmission side with respect to the relative displacement distance X of the transmitting and receiving electrodes in the aforesaid transducer 100. One can see that they change with a sinusoidal wave pattern such as that shown in the figure in accordance with the transmitted phase combination (from the first phase combination to the eight phase combination) or changes of the relative displacement distance X of both sets of electrodes.

The wave patterns of these changes of the received signals V are determined by the shapes of the electrodes in the transducer 100. In this embodiment, the shapes of the second receiving electrodes have been selected, rectangular for example, so that changes of the sinusoidal wave patterns will be obtained with respect to the relative displacement distance X when the relative positions of the first transmitting electrodes and the second receiving electrodes have changed. However, their shapes can also be selected so as to obtain signals having other wave-pattern changes such as triangular ones.

In Fig. 5, let us focus attention on only one transmission phase, for example the first phase combination. A received signal 402 like that shown by the thick line in the figure will be output from the demodulator 48 when the relative displacement distance X in the transducer 100 has changed.

In the figure, the timing when the received signals V of the first phase combination are 0 is set to correspond with the position where there is a relative displacement distance $x_1 = 0$ (500). If the relative displacement distance X of both electrodes or both scales changes from this reference position, the signal 402 received from the demodulator 48 will vary according to the sinusoidal pattern of the first phase combination shown in Fig. 5.

In Fig. 5, if the transmitted phase combination from the transmitting circuit changes, a different received signal V will necessarily be obtained from a transducer at the identical relative displacement distance X. For example, at scale position 500 ($x_2$) shown in this embodiment, if the transmission phase is changed with this transducer 100 fixed in the same position, one can understand that the signal V received at this time will be at the predetermined level of the transmitted phase combination on the line at a distance $x_2$ from $x_1$.

That is, at relative displacement distance $x_2$ (position 500), if the transmission phase of the first phase combination is supplied to the transmission electrodes 12, V1 will be obtained. After this, similarly V2 will be obtained for the second transmission phase, V3 will be obtained for the third transmission phase, and the signals indicated by V4, V5, V6, V7 and V8 will be obtained for the fourth, fifth, sixth, seventh and eighth transmission phases, respectively.

Consequently, one can understand that, when this circuit is used, if the relative displacement distance X is fixed at a specified relative measuring position (for example, $x_2$) between the first and second scales in transducer 100, the received signals V obtained can assume eight different values as a result of selecting eight different transmitted phase combinations.

Moreover, one can understand that, when this circuit is used, if a specific transmitted phase combination is selected for the relative displacement distance X, the received signals V obtained at this time will be specified within one wavelength (i.e., within $x_m$) on the receiving side, taking into consideration the gradients of the received signals V, and this will form the maximum measurement range of each phase combination. It will be clear that variations of the relative displacement distance X within this maximum measurement range will be detectable by processing the received signals V. In other words, if there has been relative displacement exceeding this maximum measurement range $x_m$, the received wave patterns will return again to the sinusoidal pattern, and it will thus become difficult to distinguish between them.

In this invention, the aforesaid maximum measurement range $x_m$ is set so as to include the entire scale length.

In this circuitry, this maximum measurement range $x_m$ is divided into a number of measuring ranges equal to the number of the transmitted phase combinations, and transmission signals of each different transmitted phase combination are assigned to each measuring range. In this embodiment, eight transmitted phase combinations have been selected, and the aforesaid maximum measurement range $x_m$ is therefore divided into eight parts, the displacement distance of which makes up the range of measurement of each phase combination. In Fig. 5, $x_a$ indicates the measurement range of the first phase combination. It is assigned to transmissions having the first phase combination.

These measurement ranges are each positioned centering around the position where the received signals V obtained in response to transmissions of the first phase combination cross zero, i.e. the $x_1 = 0$ position for the first phase shown in Fig. 5. The ranges are each positioned so as to cover 45 degrees divided by half, that is 22.5 degrees on both sides of the $x_1 = 0$ position.

Consequently, the device is configured so that each phase combination will obtain a measurement range of 45 degrees and these eight phase combinations will be able to measure the maximum measurement range $x_m$.

Once it has been understood from the foregoing that the positions within the measurement range shown by $x_a$ in Fig. 5 are measured by the first phase combination, it will also be understood that the other phases will be able to measure other ranges in a similar manner. In the following we shall explain the measuring/processing circuits with reference to the first phase combination.

In these circuits, once a transmitted phase combination has been determined, the aforesaid measurement range also will necessarily be determined. For example, if the first phase combination is selected, its reference position will be determined as $x_1 = 0$. If we find the displacement within this measurement range (i.e., $x_2$ in Fig. 5), by adding the aforesaid $x_1$ and $x_2$ we will be able to find the relative displacement distance X determined by the current transducer 100.

The characteristic feature in this invention is the fact that, in order to determine the aforesaid $x_2$, transmission signals having two different transmitted phase combinations are supplied to the first set of transmitting electrodes, and the relative displacement distance $x_2$ is found by simple processing from the two received signals obtained at this time.

The desired measured value is obtained in this embodiment by subjecting the two aforesaid received signals to positive integration, and then to inverse integration, by an integrator.

In this embodiment, the aforesaid integrator is indicated by numeral 50. It positively integrates for a definite time the analog output 402 of the demodulator 48; then it inversely integrates the received signals obtained at a different transmitting phase.

In order to simplify the explanation, it is assumed that there is a phase difference of 90 degrees at the receiving side between the transmitted phase combination of the signals subjected to the second inverse integration and those subjected to the first positive integration in this embodiment.

If there is a relative displacement distance shown by numeral 500 in Fig. 5, the transmitting electrodes of the transducer 100 are first excited by the first phase combination. The signal V received at this time will be a sinusoidal function of the relative displacement distance X:

$$V1 = k \sin x$$

Here, k is a constant.

At the state of this first transmitted phase combination, the integrator 50 will first perform positive integration for a definite time, and the integral value Vi will be obtained.

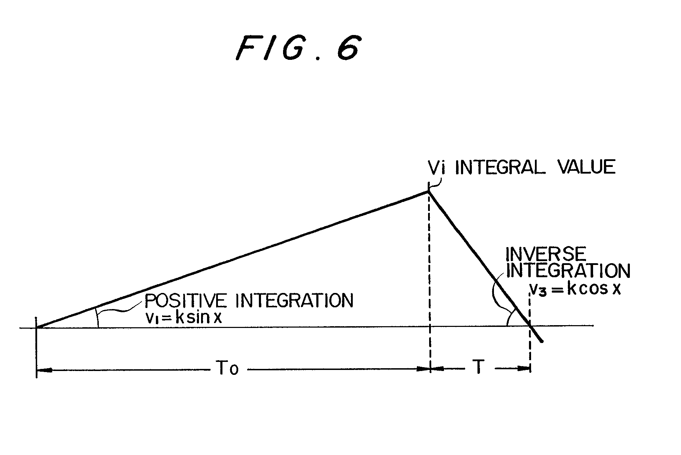

This integrating operation is plotted in Fig. 6. The positive integrating time $T_0$ is set at any specific time. The value of this specific time $T_0$ is predetermined in accordance with the resolution of the circuit. As for the integral gradient during positive integration in Fig. 6, it is clear from Fig. 5 that the received signal V is

$$V1 = k \sin x$$

Therefore, the integral value Vi after the passage of the definite time in Fig. 6 will be:

$$Vi \approx T_0 k \sin x \dots\dots\dots\dots\dots(1)$$

When the aforesaid positive integration is completed, the second transmission takes place from the transmitting circuit with a transmitted phase combination having a phase difference of 90 degrees. At this time, the relative position of the transducer 100 is unchanged, and it remains stationary at position 500 in Fig. 5. Therefore, the received signal V obtained at this time will be that obtained from the wave patterns of the third phase combination, i.e. V3. One can understand that this V3 is the cosine function of the relative displacement distance X:

$$V3 = -k \cos x$$

Consequently, the integrator 50 will perform inverse integration of the signal V3 = -k cosx received at the state of this second transmitted phase combination, and the aforesaid integral value Vi will be inversely integrated, as shown in Fig. 6, by the integral gradient of

$$V3 = -k \cos x$$

Therefore, the output 404 of the integrator 50, i.e. the integral value Vi, will assume a value of zero as a result of inverse integration, and this zero value will be detected by the analog comparator circuit 52.

In this embodiment, the analog comparator circuit 52 will produce output 406 when the output 404 of the aforesaid integrator 50 has become zero.

The time until the output 404 (Vi) of the integrator 50 reaches zero is shown by T in Fig. 6. As is clear from the figure, the following relationship applies in this inverse integration:

$$Vi \approx Tk \cos x \dots\dots\dots\dots\dots(2)$$

Consequently, the following relationship applies approximately as a result of the aforesaid positive integration and inverse integration:

$$Vi = T_0 k \sin x = T k \cos x \dots\dots\dots(3)$$

Therefore, it follows that:

$$T = T_0 \sin x/\cos x \dots\dots\dots\dots(4)$$

Since

$$\sin x/\cos x = \tan x,$$

the following is obtained:

$$T = T_0 \tan x \dots\dots\dots\dots\dots(5)$$

As was mentioned before, the measurement range assigned to each transmitted phase combination is assigned here to the vicinity of the zero position of the received signals shown in Fig. 5, that is, to a range of ±22.5 degrees. On account of this, within each measurement range the wave patterns of the received signals will be approximated in a more or less linear manner, and the following relationship will apply in regions with such small phase angles:

$$\tan x \approx x$$

Therefore, the aforesaid equation (5) will assume the following form:

$$T = T_0 x \dots\dots\dots\dots\dots(6)$$

and the following approximate equation will be obtained:

$$X = T/T_0 \dots\dots\dots\dots\dots(7)$$

In the aforesaid Vi is a minus number, X will be treated as a minus number here. In this case, $T_0$ is a constant value. Therefore, one can understand that, if the aforesaid inverse integration time T is found, one can find the relative displacement distance X within the measurement range ($x_2$ in this case) by simple arithmetical processing.

In this embodiment, this arithmetical processing is performed by a counter 54. The counter 54 is started by signals from the control unit 44 at the beginning of the aforesaid inverse integration and is stopped by the output 406 from the aforesaid analog comparator circuit 52. It counts the output $f_0$ of the aforesaid oscillator 40 as clock signals, and its output 408 will indicate the aforesaid inverse integration time T.

Therefore, $x_2$ can be found if the aforesaid inverse integration time T is supplied to the arithmetic unit 56 and the arithmetical processing of the aforesaid equation (7) is performed by a command from the control unit 44. In addition, since the control unit 44 supplies to the arithmetic unit 56 the first transmitted phase combination which served as the reference at this time, the desired relative displacement distance X can be found by addition with the known $x_1$, which is determined from this first transmitted phase combination.

In this embodiment, this relative displacement distance passes through a display driver 58 and is displayed as a measured value on a display unit 60.

The relative displacement distance at each selected transmitted phase combination is calculated as described above. However, as mentioned above, the measurement range of each phase is limited to a range of 22.5 degrees before and after the first transmitted phase combination, which is the reference. If this range is exceeded, the aforesaid linear approximation will be difficult, and this will be a major factor causing errors.

For this reason, in this embodiment, the comparator 62 compares the output of the aforesaid counter 54 with the output of the upper-limit setting device 64. If the aforesaid inverse integration time T has exceeded the upper limit value, it outputs a signal to the control unit 44 to the effect that measurement is impossible, and the transmitted phase combination is switched over to the first phase combination which is used as the reference.

Consequently, if the phase displacement distance which is sought is not within the measurement range of the first transmitted phase combination which was selected when measurement was started, the next transmitted phase combination is selected, and the first transmitted phase combinations are tried repeatedly one after another until the output of the counter 54, i.e. the inverse integration time T, comes within the limit value. Since a maximum of eight repeated measurements are taken, it will be possible to obtain a high-precision measured value without fail.

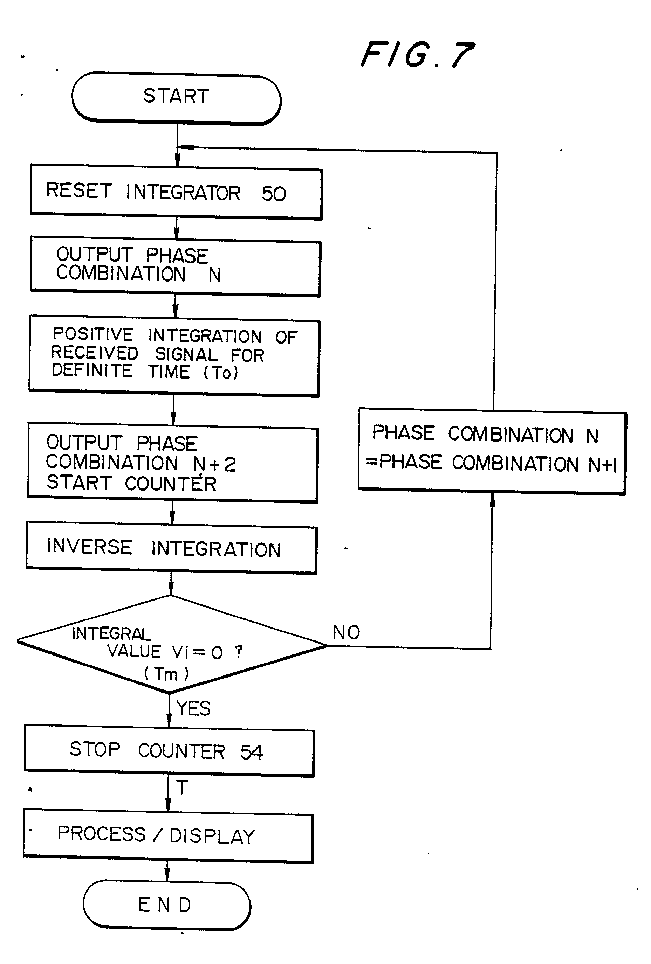

Fig. 7 illustrates the overall flow of the measuring operations of this invention.

Once the measurement position is determined by the transducer 100, the circuitry enters the state where measurement is started. First, the contents of the integrator 50 is reset.

Next, an optional specified phase combination is set on the oscillator circuit side, and A.C. signals modulated with phase combination N are supplied to the transmitting electrodes.

The signals V received for a definite time ($T_0$) at the state of transmission at this phase combination N are integrated.

The integrator 50 will hold the integral value Vi resulting from this positive integration.

Next, the phase combination transmitted by the transmitting circuit will be changed to phase combination N + 2, that is, to a transmitted phase combination with a difference of 90 degrees from the aforesaid first transmitted phase combination. The signals received from the transducer 100 at this state are detected.

The counting operations of the counter 54 started at the same time that this phase combination N + 2 is output, and at the same time the integrator 50 performs inverse integration of the aforesaid integral value Vi.

The integral value Vi is monitored by the analog comparator circuit 52, which determines whether the integral value Vi becomes zero within the upper limit value Tm set by the upper-limit setting device 64. If the inverse integration time T is too large at this time, it assumes that the first transmitted phase combination is not appropriate, and the aforesaid operations are repeated again at phase combination N + 1.

These integration operations are repeated until the inverse integral value Vi becomes zero within the upper limit value Tm. When the desired output has been obtained, the counter 54 is stopped, this inverse integration time T is calculated and displayed on the display unit 60. At this, the series of measurements is completed.

As is clear from the foregoing explanation, using this example will make it possible to find the relative displacement distance accurately by obtaining different received signals with two transmitted phase combinations having a phase difference of 90 degrees and by processing them arithmetically.

Of course, the number of divisions of the transmitted phase combinations in this invention is not limited only to eight, and any number of them can be selected. Moreover, the two different transmitted phase combinations can be set at a phase difference of 45 degrees, rather than 90 degrees, as given in this embodiment. In the embodiment given above, when a 90-degree phase difference is used, the received signals obtained when both phase combinations are transmitted will be combinations of sine signals and cosine signals, and it is easy to calculate them. However, when the phase difference between them is 45 degrees, it will also be possible to find the relative displacement distance by carrying out the predetermined arithmetical processing of functions in a similar way.

As described above, if this invention is applied, it is possible to calculate the desired measured values by sending two transmission signals having different phase combinations one after another to the transmitting electrodes, and by using the two received signals obtained at this time (in this embodiment) in a combination of positive integration and inverse integration.

In the foregoing explanation, it is said that the first and second received signals are stored in memory for positive integration and inverse integration by the integrator, but it is also possible in this invention to store them in the memory simply as digital signal values, which can then be subjected to digital calculations on the basis of predetermined calculating equations.

As was explained above, if this invention is applied, when measuring the amount of relative displacement between two structural members which are displaced in relation to each other (usually the displacement between a first and second scales) in terms of absolute values as changes in electrostatic capacity, it is possible to find the desired relative displacement distance by transmitting two signals with different phase combinations to the transmitting electrodes and storing and then processing the received signals obtained at this time. As a result, this makes it possible to obtain high-speed processing with a high precision and with no delays, unlike the case with the conventional methods in which the measured values were found with single transmission signals.

## Claims

(1) A method for detecting signals of capacitance type transducers for measuring positions in which there are a first scale and a second scale which are displaced relatively to each other, A.C. signals are supplied to transmitting electrodes provided on the first scale, receiving electrodes provided on the second scale are coupled capacitively with the aforesaid transmitting electrodes, and the relative displacement distance between the aforesaid two scales is measured by finding, from the detection signals derived from the receiving electrodes, the capacity value, which varies according to the relative displacement distance between both scales;

the method comprising:

first storing the first receiving signals detected from the receiving electrodes in a memory when first transmission signals of a specified phase combination are supplied to the group of transmitting electrodes,

second, storing the second receiving signals detected from the receiving electrodes in a memory when second transmission signals with a phase combination which is different from the aforesaid specified phase combination are supplied to the group of transmitting electrodes,

and processing the two aforesaid received signals for obtaining the relative displacement between the two scales.

(2) A method for detecting signals of capacitance type transducers for measuring positions in which there are a first scale and a second scale which are displaced relatively to each other, A.C. signals are supplied to transmitting electrodes provided on the first scale, receiving electrodes provided on the second scale are coupled capacitively with the aforesaid transmitting electrodes, and the relative displacement distance between the aforesaid two scales is measured by finding, from the detection signals derived from the receiving electrodes, the capacity value, which varies according to the relative displacement distance between both scales;

positive integration of the first receiving signals detected from the receiving electrodes for a predetermined period when first transmission signals of a specified phase combination are supplied to the group of transmitting electrodes,

inverse integration of the aforesaid positive integral value by the second receiving signals when second transmission signals with a phase combination which is different from the specified phase combination are supplied to the group of transmitting electrodes,

detecting the relative displacement distance between the two scales by the inverse integration time until the inverse integral value becomes zero.

(3) A method for detecting signals of capacitance type transducers for measuring positions characterized by the fact that, in the method described in Claim (2), positive integration and inverse integration are performed changing the first transmitted phase combinations which are to serve as the reference to new phase combinations when the aforesaid inverse integration time has exceeded a predetermined upper limit value;

and the aforesaid changes of the transmitted phase combinations are repeated one after another until the inverse integration time fits within a predetermined value.

(4) A method for detecting signals of capacitance type transducers for measuring positions characterized by the fact that, in the method described in Claims (1) and (2), there is a phase difference of 90 degrees between a specific phase combination and the second phase combination.

(5) Circuitry for detecting signals of capacitance type transducers for measuring positions, comprising a transmitting circuit which supplies a number of A.C. signals modulated with different phases to the transmitting electrodes of the first scale, and

a measuring circuit which measures the amount of displacement between the two sets of electrodes from the phase differences between transmission and reception on the basis of the signals received from the receiving electrodes, which are coupled capacitively with the transmitting electrodes located on the second scale, which is displaced relatively to the aforesaid first scale;

said circuitry for detecting signals of capacitance type transducers for measuring positions being characterized by the fact that the transmitting circuit has a transmitting phase switching circuit which supplies the group of transmitting electrodes with A.C. signals modulated with any specified phase combination;

and the measuring circuit has an integrator which subjects the signals received at the transmission state at the first specified phase combination to positive integration for a definite time, and then subjects the integral values to inverse integration by means of the second signals received at the second phase combination, which have a predetermined phase difference from the aforesaid first phase combination,

a comparator circuit which, when the inverse integral value of the aforesaid integrator has reached a predetermined value, detects this fact,

a counter which counts the inverse integration time until the aforesaid predetermined value is reached,

and an arithmetic unit which calculates the relative displacement distance between the two scales from the value counted by the aforesaid counter.

(6) Circuitry for detecting signals of capacitance type transducers for measuring positions, characterized by the fact that the circuitry described in Claim (5) comprises:

a comparator, which compares the inverse integration time with a predetermined upper limit value, and a control unit which, in accordance with the output of said comparator, switches one by one the specified first phase combinations which are to serve as the reference when the inverse integration time has exceeded the upper limit value, and the optimal specified phase combination can be selected.

# FIG. 1

0 241 913

## FIG. 2

## FIG. 3

| | P1 | P2 | P3 | P4 | P5 | P6 | P7 | P8 |
|---|---|---|---|---|---|---|---|---|
| PHASE COMBINATION 0° | O | O | O | O | I | I | I | I |
| PHASE COMBINATION 45° | I | O | O | O | O | I | I | I |
| PHASE COMBINATION 90° | I | I | O | O | O | O | I | I |
| PHASE COMBINATION 135° | I | I | I | O | O | O | O | I |
| PHASE COMBINATION 180° | I | I | I | I | O | O | O | O |
| PHASE COMBINATION 225° | O | I | I | I | I | O | O | O |
| PHASE COMBINATION 270° | O | O | I | I | I | I | O | O |
| PHASE COMBINATION 315° | O | O | O | I | I | I | I | O |

# FIG. 4

OUTPUT fo OF OSC 40

1st PHASE COMBINATION

3rd PHASE COMBINATION

TRANSMITTED SIGNALS

400-1
400-2
400-3
400-4
400-5
400-6
400-7
400-8

RECEIVED SIGNALS

402-1  $v_1 = k \sin x$

402-2  $v_3 = k \cos x$

OUTPUT 404 OF INTEGRATOR 50

OUTPUT 406 OF ANALOG COMP. 52

START     STOP

OUTPUT 408 OF COUNTER 54

FIG. 5

# FIG. 6

Vi INTEGRAL VALUE

INVERSE
INTEGRATION
$v_3 = k \cos x$

POSITIVE INTEGRATION
$v_1 = k \sin x$

To

T

# FIG. 7

```
        START
          │
          ▼
┌──────────────────────┐
│ RESET INTEGRATOR  50 │
└──────────────────────┘
          │
          ▼
┌──────────────────────┐
│ OUTPUT  PHASE        │
│ COMBINATION   N      │
└──────────────────────┘
          │
          ▼
┌──────────────────────┐
│ POSITIVE  INTEGRATION OF │
│ RECEIVED  SIGNAL  FOR    │
│ DEFINITE  TIME  (To)     │
└──────────────────────┘
          │
          ▼
┌──────────────────────┐          ┌────────────────────────────┐
│ OUTPUT  PHASE        │          │ PHASE  COMBINATION  N      │
│ COMBINATION  N+2     │          │ =PHASE  COMBINATION  N+1   │
│ START  COUNTER       │          └────────────────────────────┘
└──────────────────────┘                        ▲
          │                                      │
          ▼                                      │
┌──────────────────────┐                         │
│ INVERSE  INTEGRATION │                         │
└──────────────────────┘                         │
          │                                      │
          ▼                                      │
      ╱INTEGRAL ╲          NO                     │
     ╱ VALUE Vi=0 ? ╲──────────────────────────────
     ╲   (Tm)      ╱
      ╲         ╱
          │ YES
          ▼
┌──────────────────────┐
│ STOP  COUNTER  54    │
└──────────────────────┘
          │ T
          ▼
┌──────────────────────┐
│ PROCESS / DISPLAY    │
└──────────────────────┘
          │
          ▼
        END
```

FIG.8

MEASURING CIRCUIT ~32

PHASE CONVERTER

30
OSC

~34

14

RELATIVE DIS-PLACEMENT x

10 1st SCALE

12 1st TRANSMITTING ELECTRODES

24

26

20 2nd SCALE

22 2nd RECEIVING ELECTRODES

0 241 913